## Europäisches Patentamt
## European Patent Office
## Office européen des brevets

(19)

(11) Publication number: **0 016 646**
**B1**

(12) **EUROPEAN PATENT SPECIFICATION**

(45) Date of publication of patent specification: **21.09.83**

(21) Application number: **80300887.9**

(22) Date of filing: **21.03.80**

(51) Int. Cl.³: **H 03 K 17/13,**
**H 03 K 17/292,**
**H 02 M 5/45**

(54) **AC Solid-state circuit breaker.**

(30) Priority: **23.03.79 US 23368**
**23.03.79 US 23361**

(43) Date of publication of application:
**01.10.80 Bulletin 80/20**

(45) Publication of the grant of the patent:
**21.09.83 Bulletin 83/38**

(84) Designated Contracting States:
**DE FR GB**

(56) References cited:
**DE - A - 1 438 629**
**FR - A - 2 400 286**
**US - A - 3 879 652**

**ELECTRONIQUE INDUSTRIELLE no. 85,**
**July/August 1965, page 321 Paris, FR. T.**
**WYSEN: "Alimentation à diodes commandées"**

(73) Proprietor: **WESTINGHOUSE ELECTRIC**
**CORPORATION**
**Westinghouse Building Gateway Center**
**Pittsburgh Pennsylvania 15222 (US)**

(72) Inventor: **Mitchell, James Thomas**
**147 Burlington Place**
**Lima Ohio (US)**
Inventor: **Billings, William Weaver**
**4007 Statesman**
**Cridersville Ohio (US)**
Inventor: **Leubrecht, Richard Elmer**
**823 Carnation Drive**
**Wapakoneta Ohio (US)**

(74) Representative: **van Berlyn, Ronald Gilbert**
**23, Centre Heights**
**London, NW3 6JG (GB)**

Courier Press, Leamington Spa, England.

# 0 016 646

## AC Solid-state circuit breaker

This invention relates generally to solid-state circuit breakers for controlling the supply of power from an AC supply to a load and particularly to such circuit breakers that are suitable for applications in which size and weight must be minimized and reliability must be enhanced while retaining the functional advantages offered by conventional electromechanical apparatus.

In U.S. Patent 3,879,652, to Billings, granted April 22, 1975, there is disclosed an AC solid-state power controller, having the features recited in the precharacterising part of claim 1, which is quite satisfactory for its intended purposes, and is generally referred to by the term "power controller" which term could also be applied generally to the present invention. However, it is preferred herein instead to refer to the present apparatus as a solid-state "circuit breaker" to convey the suggestion that the apparatus described herein has capability for interruption in response to a manually actuated element or switch, as an electromechanical circuit breaker does, in addition to the internal power control functions which it may be additionally capable of.

Conventional circuit breakers have an off/on/reset toggle switch utilizing magnetic and thermally responsive elements, which is a desirable feature and affords flexibility and convenience in the testing, maintenance and use of the breaker. Additionally, electromechanical breakers have the quality of power contact, meaning that the closed or "on" position provides direct conduction of power to the load with negligible impedance and upon interruption there is a clean break imposing an infinite impedance in the load circuit. Such apparatus is also usually designed to be capable of inverse-time overload trip protection. Also, conventional circuit breakers can readily be provided with means for status indication of the contacts. All these functions are desirably to be achieved in a solid-state circuit breaker which avoids problems of mechanical wear, reliability, and bulk.

Among the features not provided by conventional type circuit breakers is a means for insuring occurrence of the closing or interruption function to synchronize with a predetermined point in the applied power wave form. Such synchronism becomes an important objective in designing a solid-state circuit breaker because the power switch elements, normally thyristors, unlike mechanical contacts, are particularly dependent in their operation and performance on the applied wave shape.

Also, conventional circuit breakers inherently exhibit overload protection within too wide a tolerance range which is desirably to be made more precise.

Other features of conventional circuit breakers tending to make them less desirable in situations requiring high reliability is that they are affected by ambient temperature, dust, moisture, and the like, and exhibit relatively low physical strength and endurance to shock and vibration.

Described herein is a solid-state circuit breaker apparatus with the good qualities of electromechanical circuit breakers while markedly improving on other poorer qualities so that the apparatus is capable of performance with high reliability in a compact and low weight structure making it particularly suitable for use in aerospace, military and other applications where these performance advantages are desirable.

The invention in its broad form resides in a solid-state circuit breaker for alternating current applications such as for use in between an AC voltage supply and a load, of the type comprising a solid-state power switch for connection between an AC voltage supply and a load; power supply means for developing a control-DC voltage from the applied AC voltage; a manually operable control switch; zero cross-over-circuit means having connections with the AC voltage supply and with said power supply means for producing a signal indicative of the zero crossover of at least one phase of the AC voltage supply; control logic means to supply an ON signal when the zero crossover signal occurs; and drive circuit means responsive to the ON signal for application of signals to the power switch to initiate conduction thereof, characterized by: said manually operable control switch being connected between the AC voltage supply and said power supply means; said zero crossover-circuit means being connected to the AC voltage supply both directly and through said control switch and said power supply means, for producing a said signal indicative of the zero crossover of at least one phase of the AC supply; a turn-on time delay circuit means provided for producing a signal indicative of said power supply means having achieved full operating capability after the closing of said control switch; switch detector circuit means provided for producing a signal in response to both the closing of said control switch and the occurrence of the signal from said turn-on time delay circuit means; and said control logic means producing an ON signal only when said zero crossover signal occurs in the presence of the signal from the switch detector circuit means.

In a preferred embodiment of a solid-state circuit breaker is provided circuitry for permitting off/on/reset operations actuated by a mechanical toggle control switch for close simulation of magnetic circuit breaker operation. Locating the control switch so that it opens essentially all of the circuitry except for the static power switch branch, between the source and the load, provides a high degree of fail-safe protection for the apparatus, or a power removal feature. A power continuity feature includes means for zero crossover synchronization both upon power-up and power-down conditions with full sine wave conduction through the solid-state power switch regardless of the instant at which the manual control switch is opened or closed. A circuit lockout feature is used so that on power-up, or

2

**0016646**

turn-on, operation is delayed until the occurrence of an internal power-ready condition. On power-down, or turn-off, there is means for circuit retention subsequent to switch opening and internal power removal in order to accomplish load turn-off at a desired zero crossover point of the load power through the power switch. A power supply is incorporated that does not require stepdown or isolation transformers and improves capability for miniaturization of the overall circuitry and enables design of the circuit for operation at any of a wide range of frequencies, such as 60 Hz to 400 Hz.

In a second embodiment, a circuit breaker for three phase AC applications is described.

The invention is generally an improvement on the "power controllers" such as that of United States Patent 3,879,652 in order to achieve additional "circuit breaker" functions.

The invention will be more apparent from the following description of a preferred embodiment described by way of example and to be read in conjunction with the accompanying drawings wherein:

Figure 1 is a functional block diagram of apparatus in accordance with an embodiment of the present invention;

Figure 2 is a detailed circuit schematic of an embodiment of this invention; and

Figure 3 is a set of waveforms illustrative of the operation of the embodiments of apparatus in accordance with this invention;

Figure 4 is a functional block diagram of apparatus in accordance with an embodiment of the present invention for three phase AC power supplies;

Figure 5 is a detailed circuit schematic of an embodiment of this invention for a three phase AC power supply;

Figure 6 is a set of waveforms illustrative of the operation of an embodiment for three phase applications; and

Figures 7 through 11 illustrate input connections for embodiments of the invention to show the versatility of applications to which the invention may be applied.

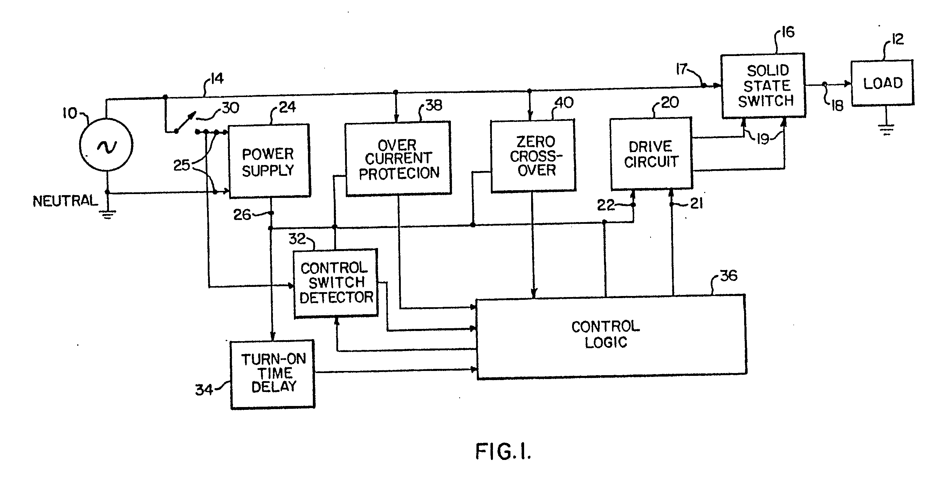

Referring to Figure 1, a solid-state circuit breaker is illustrated, in a one-line diagram, for controlling the supply of power from an AC supply 10 to a load 12 on an AC line 14. A solid-state switch 16, sometimes referred to as a static power switch or the like, has supply and load terminals 17 and 18 connected respectively to the supply 10 and load 12 and also has drive terminals 19 for the selective application of predetermined drive signals to alter the conduction state of the switch.

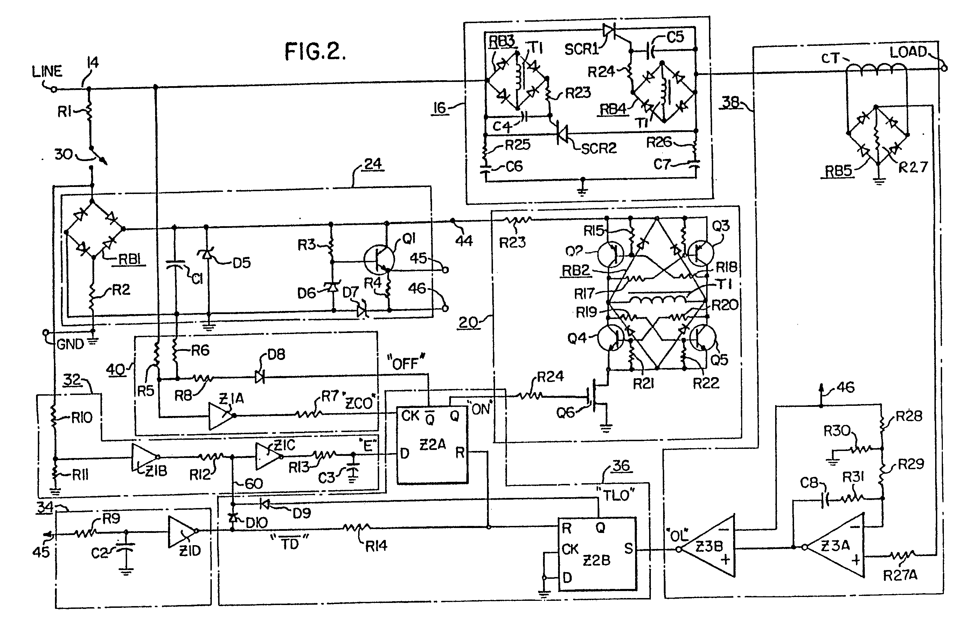

Various switch configurations may be employed in the practice of this invention. A switch principally comprising a pair of inverse parallel thyristors is presently preferred. The power switch portion of the circuit may also include rectifier and filter elements, see Figure 2.

A drive circuit 20 is provided for applying drive signals to the power switch 16. The drive circuit 20 is shown having output terminals electrically coupled to the drive terminals 19 of the power switch 16, as well as a control input terminal 21 for receiving control signals to which it responds as well as a power supply terminal 22, but it is to be understood this representation is for generally descriptive purposes rather than precise definition of which elements fall within which circuit block. For example, the circuit for the power switch 16 and the drive circuit 20 in the preferred embodiment of Figure 2 is such that the relation of the two is inductive rather than by direct electrical connection.

A power supply circuit 24 is provided that has input terminals 25 for connection to the AC supply, through a manual control switch 30, and to a reference potential (ground or neutral) and also has an output terminal 26 connected to the drive circuit 20 as well as to other circuit portions. The power supply circuit 24 comprises elements for the conversion of AC power to DC power with whatever filtering and regulation is desirable. It is to be noted that the apparatus of the present invention preserves certain of the features of the apparatus of Patent 3,879,652 that permits the various circuits to be powered merely from the AC line without requiring any separate DC power supply unassociated with the line. Thus, this apparatus may also be referred to as "self-powered" or "self-energized".

The control switch 30 between the line 14 and the power supply 24 enables total deenergization of the circuit breaker, except for the solid-state switch 16 and except for the zero crossover circuit 40, to provide a highly reliable means of removing load power.

There is provided a means for detecting the closing of the control switch 30, shown in Figure 1 as a control switch detector circuit 32. There is also a turn-on time delay circuit 34 to insure that upon the control switch 30 being closed the power supply 24 can reach a voltage level adequate to continuously operate.

Signals from the control switch detector 32 and the turn-on time delay 34 are supplied to a control logic circuit portion 36. The control logic circuit 36 provides signals to the drive circuit 20 and is responsive, besides to the control switch detector 32 and time delay 34 circuits, to other detected conditions of the apparatus by means of an overcurrent protection circuit 38 and a zero crossover circuit 40.

The zero crossover circuit 40 is to permit accurate turn-on and turn-off synchronization for the circuit breaker with respect to the AC supply voltage waveform and preferred forms of such zero crossover circuit will be described hereinafter. The zero crossover circuit 40, control switch detector 32, and turn-on time delay 34 are significant in enabling the desired circuit breaker performance from the apparatus of this invention.

3

The overload protection circuit provides inverse time overload tripping in the event of excessive loads or load faults.

In contrast to the apparatus of prior Patent 3,879,652, the apparatus of Figure 1 differs in the provision of the control switch 30 for manual toggling of the circuit breaker and the control switch detector 32 and turn-on time delay 34 which together with the zero crossover circuit 40 provide a signal to insure correct operation of the drive circuit 20 for the solid-state switch 16 in accordance with the voltage supply wave form.

An additional function that can be provided in accordance with the skill of the art, although not illustrated, is an indication function to indicate closure of the circuit breaker in either the "on" or "tripped" condition or to indicate the "off" condition.

The nature and operation of circuit breakers in accordance with this invention will be better understood by reference to Figure 2 which shows a more specific embodiment in accordance with this invention. Control switch 30 is connected between the line 14 and the power supply 24 with a voltage dropping resistor R1 between it and the line. In the power supply 24, the AC line voltage is rectified by a full wave rectifier bridge RB1. Dropping resistor R2, connected between the bridge and the ground or neutral lead, and R1 provide both voltage limiting for the power supply and a measure of immunity against circuit breaker misconnections. Capacitor C1 filters the rectified voltage from the bridge and zener diode D5 limits the +DC voltage at point 44 in the tripped state and under severe overvoltage transient conditions. Resistors R3 and R4, zener diodes D6 and D7, and transistor Q1, connected as shown, provide lower, regulated, DC voltage levels at output terminals 45 and 46 for other circuit portions to be described. The higher +DC voltage at 44 is supplied on a line to the drive circuit 20 to be described subsequently.

As can be readily seen, the power supply 24 and the other circuit portions dependent on it are totally deenergized when the control switch 30 is in the open position. This provides a highly reliable means of removing load power for circuit breaker functioning.

The zero crossover circuit 40 has resistor R5 directly connecting it to the line 14 and resistor R6 connecting it to the power supply 24 at ground. Amplifier element Z1A, having its input connected to R5, provides an amplified zero crossover signal or "ZCO" signal through resistor R7 to the control logic circuit 36. In the line connecting the common terminal of R5 and R6 with the "OFF" signal of the control logic circuit 36 is resistor R8 and diode D8 for providing a bias for the "ZCO" signal. A purpose of the zero crossover circuit 40 is to provide accurate turn-on and turn-off synchronization for the solid-state circuit breaker with respect to an AC supply voltage zero crossover. This circuit senses the line-to-ground voltage and generates a quasi-square wave whose positive rising edges define zero crossover operating times that coincide with the 180° zero crossings of the AC source voltage.

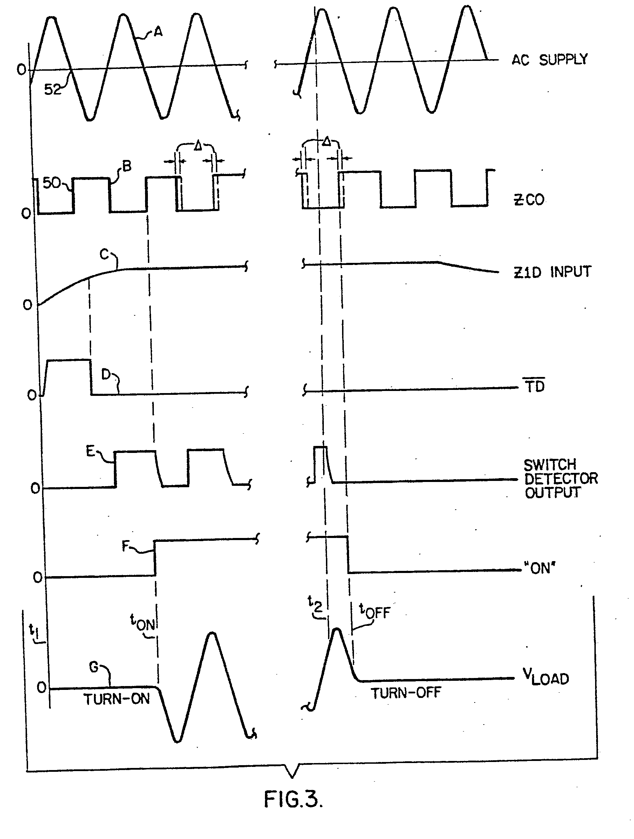

In Figure 3, curve A shows the AC supply voltage waveform and curve B shows the zero crossover signal ZCO from which it can be seen that each rising edge of the zero crossover signal, such as 50, occurs when the supply voltage is crossing zero from plus to minus, at 52. In the illustrated embodiment, it is advantageous to utilize the negative going zero crossover point (the 180° crossover) for the zero crossover signal. This selection is made in order to attain the power continuity feature which reduces turn-on saturation and transients particularly when the breaker is used in an electromagnetic load circuit. Reference is made to Billings and Tipton Patent 3,914,625, October 21, 1975, for further description of desirable characteristics of zero crossover circuits in solid-state power control apparatus.

It is particularly to be noted that the AC input signal to the zero crossover circuit 40 through R5 is independent of the control switch 30 being closed so that on turn-off proper synchronization with the 180° zero crossover point will be maintained. There is also deliberate early occurrence of the zero crossover signal positive leading edge obtained in the ON state to preclude extra half-cycle load power by leading power factor load currents. This latter function is accomplished by loading the zero crossover input sensing node in the ON state by R8 and D8 to the OFF signal which is low when the circuit breaker is ON.

In Figure 3, waveform B, the occurrence of the shift in ZCO in the ON state is shown by the $\Delta$ symbol. For the circuit of the specific embodiment of Figure 2, $\Delta$ equals about 18°.

The turn-on time delay circuit 34, which might also be called a "power ready" circuit, has an RC charging circuit portion comprising resistor R9 and capacitor C2 between the power supply point 45 and logic element Z1D whose output is supplied to the control logic circuit 36. The turn-on time delay circuit 34 generates inhibiting and reset logic signals subsequent to the closing of the control switch. These signals keep the circuit breaker in the OFF state until the power supply has reached a voltage level adequate to continuously operate. The inhibiting signals are used to preset both sections Z2A and Z2B of dual flip-flop Z2 in the control logic circuit 36 to the OFF state. In practice, the time delay afforded is quite short, such as 15 milliseconds, to permit reaching the threshold level of Z1D in that time and to cause it to go from logical one to a zero output state. Waveforms C and $\underline{D}$ of Figure 3 show, respectively, the time delay sensing signal at the input of Z1D and the logic signal of $\overline{TD}$.

The switch detector circuit portion 32 includes resistors R10 and R11 connected between the control switch 30 and ground. The point between those resistors is connected to the input of Z1B whose output is connected through resistor R12 to Z1C, resistor R13 and subsequently to a terminal of the control logic circuit 36. Capacitor C3 is connected between the output of the detector circuit 32 and ground. The input of Z1C is also connected directly to a part of the control logic circuit 32 on line 60.

The switch detector circuit 32 provides a logic signal that turns the circuit breaker on and off in response to the control switch 30. The output signal that is generated, shown in curve E of Figure 3, is a quasi-square wave rather than a continuous "on" signal. This pulsating signal is obtained whenever the control switch 30 is closed and is generated in a manner similar to that of the zero crossover signal but is inverted by an additional logic gate element, Z1C, and time delayed by R13 and C3 so that the control signal "E" generated always is positive at the instant the zero crossover signal is produced, as long as the control switch is closed, other than during the turn-on time delay period.

In the control logic circuit portion 36, the main logic elements are the two parts of a dual D flip-flop, Z2A and Z2B. Z2A provides the OFF signal to the zero crossover circuit from terminal $\bar{Q}$; it receives the zero crossover signal "ZCO" at terminal CK from the zero crossover circuit; it receives the switch detector output signal "E" at its terminal D and it sterminal R recieives the $\overline{TD}$ signal and is directly connected to terminal R of Z2B. A line from the turn-on time delay circuit 34 is connected through resistor R14 to terminal R of Z2B. There is also a connection from terminal Q of Z2B through diode D9 at a point common with the input to Z1C in the switch detector circuit. Also, that point is connected through diode D10 to the output of the turn-on time delay circuit. Z2B has a further input at terminal S from the overload protection circuit, to be described. The terminals CK and D of Z2B are connected together and to ground.

The control logic circuit produces an ON signal from terminal Q of Z2A for the drive circuit 20 upon occurrence of the correct sequence of events. In Figure 3, part F shows the ON signal and how it correlates with the various other logic and AC signals.

In operation, when the control switch 30 is opened, the control signal "E" from the switch detector disappears so that the circuit breaker will shut-off at the next zero crossover operating time. This manner of shutoff provides two significant features, namely that it is proper for load power continuity and also that it occurs in a maximum time of one cycle from control switch opening so as to assure adequate energy is available in the power supply to maintain energization for various circuit breaker circuits.

The drive circuit 20 principally includes a Royer-type square wave oscillator comprising transistors Q2, Q3, Q4 and Q5 in a bridge configuration within which is arranged a rectifier bridge RB2 with resistors R15 through R22 connected as shown. The drive circuit 20 gets its supply from the high +DC voltage from the power supply through resistor R23 and also gets an ON signal through resistor R24 from the control logic circuit 36. R24 is connected to the input of a field effect transistor Q6 connected with the transistor bridge elements Q4 and Q5. Across the transistor and diode bridges of the drive circuit is the primary winding of transformer T1 whose secondary windings are within the power switch circuit portion 16 as will be described.

The function of the drive circuit 20 is to amplify the "ON" signal and provide two electrically isolated thyristor gate signals for the static power switch 16. The drive circuit uses a Royer square wave oscillator with its transistors connected in a bridge configuration rather than a conventional center-tapped configuration. This allows the use of a single primary winding for transformer T1 instead of a two-section winding, with a consequent 50% reduction in number of turns, and the collector-to-emitter voltage rating of the transistors is half that required of a center-tapped circuit, which would require the use of higher voltage devices.

In the static power switch 16 the main switch elements are SCR1 and SCR2 connected in inverse parallel configuration directly in the load circuit. The SCR gate terminals are connected to respective diode bridges RB3 and RB4 across each of which a separate secondary winding of the transformer T1 is connected so that the signal from these windings is applied to the gates through respective resistors R23 and R24. There are also shown capacitors C4 and C5 connected respectively with the gates of SCR2 and SCR1. Each side of the power switch 16 is connected to ground through respective resistors R25 and R26 and capacitors C6 and C7.

The SCR's provide a full cycle conduction path for load current and are controlled by their gate signals in a timewise fashion to assure operating at the 180° crossover point of the AC power source. Filtering and bypassing are provided by the capacitors C4 and C5 and the input and output snubbers comprising respectively R25 and C6 and R26 and C7.

The overload protection circuit 38 has current transformer CT associated with the line on the load side of the power switch 16 that gets a signal that is rectified by bridge RB5 across which is connected resistor R27. The signal produced by the current transformer and bridge is supplied through R27A to an input of operational amplifier element Z3A whose output is connected to an input of operational amplifier element Z3B. The overload protection circuit receives low voltage DC at point 46 from the power supply as a reference so that elements R28 through R31 and capacitor C8 cooperate to sense, integrate and compare the sensed overload signal to provide an overload trip signal OL at the output of Z3B applied to the control logic circuit, which sets the trip lockout, TLO, flip-flop signal utilized in the control logic circuit 36. The trip lockout signal TLO in turn causes the removal of the control signal from the switch detector 32 so as to effect circuit breaker shutoff.

5

As an alternative to the illustrated overload protection circuit 38, there may be used a precision rectifier operational amplifier circuit that may be designed to reduce the size of the current transformer at the expense of some additional circuit complexity.

If an indication function were to be obtained in the illustrated circuit, closure would be indicated simply by adding a third secondary winding to T1 to obtain a base drive signal for a transistor which would be conducting in the circuit breaker ON state and nonconducting in the OFF state. An optional means would be to use optical isolator techniques. Also a circuit breaker TRIP condition could be indicated in addition to or instead of the ON state condition.

The waveforms and sequences illustrated in Figure 3 are believed particularly instructive of the manner of operation of the circuitry in accordance with this invention. It is assumed that the control switch 30 is open and the circuit breaker is OFF prior to time $t_1$. At $t_1$ it is assumed the manual control switch 30 is closed and that it remains closed until time $t_2$ at which time it is opened. In an initial period between $t_1$ and $t_{ON}$ the load voltage illustrated in curve G remains zero. However, the zero crossover signal, curve B, is generated and the time delay sensing signal, curve C, builds up gradually over a first interval to a point at which $\overline{TD}$ is terminated as shown in curve D. Following occurrence of the $\overline{TD}$ signal, the switch detector output signal, curve E, occurs in coordination with the zero crossover signal ZCO. At the instant $t_{ON}$ when there is a positive switch detector signal "E" and the correct (i.e.: positive rising edge, 50) zero crossover signal there is an ON signal, curve F, produced to the drive circuit that turns on the load voltage. This voltage will continue to be ON until both the opening of the manual control switch at time $t_2$ and the occurrence of the change of state of the ON signal in coincidence with the next correct zero crossover signal.

The following components are identified by way of example for a specific operable embodiment that was built and verified, the circuit design having all the desired characteristics:

Performance table

| Nominal rating | 120 VRMS/20 amperes |
|---|---|
| Temperature ambient range tested | −25°C to 75°C |
| AC Source voltage range | 89 VRMS to 135 VRMS |
| AC Source frequencies | 60 Hz and 400 Hz |
| SSCB Dissipation/efficiency at rated load | 28.2 W/98.9% |
| "Off" state dissipation | .01 W* |
| "Tripped" state dissipation | 2.3 W* |
| *Includes power switch leakage dissipation | |
| DC Power supply levels: | |
| +DC, at point 44 | +60 V (ON state) |
| at point 45 | +12 V |
| at point 46 | +6.4 V |

Component table

| R1, R2 | 1,000 | ohms | each |
|---|---|---|---|
| R3 | 100,000 | „ | |
| R4, R15, R16, R21, R22 | 5,000 | „ | each |
| R5, R7, R11, R12, R14 | 500,000 | „ | each |
| R6 | 250,000 | „ | |
| R8, R13 | 50,000 | „ | each |
| R9 | 357,000 | „ | |
| R10 | 1 Meg | „ | |
| R17, R18, R19, R20 | 62,000 | „ | each |
| R23, R24 | 22 | „ | each |
| R25, R26 | 47 | „ | each |
| R27 | 2.5 | „ | |
| R27A, R29 | 174,000 | „ | each |
| R28 | 30,100 | „ | |
| R30 | 603 | „ | |
| R31 | 97,600 | „ | |
| C1 | 10 | mf | |
| C2, C8 | 0.05 | „ | each |
| C3, C6, C7 | 0.01 | „ | each |
| C4, C5 | 0.068 | „ | each |
| RB1, RB2, RB3, RB4, RB5 | VE 18 X each | | |
| Q1, Q4, Q5 | 2N3019 each | | |
| Q2, Q3 | 2N5679 each | | |
| Q6 | 2N6660 | | |

Component table (contd.)

| | |
|---|---|
| Z1A, Z1B, Z1C and Z1D | Sections of MC14584B hexagonal Schmitt trigger (CMOS) |
| Z2A and Z2B | Sections of MC14013B dual "D" flip-flop (CMOS) |
| Z3A and Z3B | Sections of LM124 Quad op amp |
| SCR1 and SCR2 | 2N3898 each |

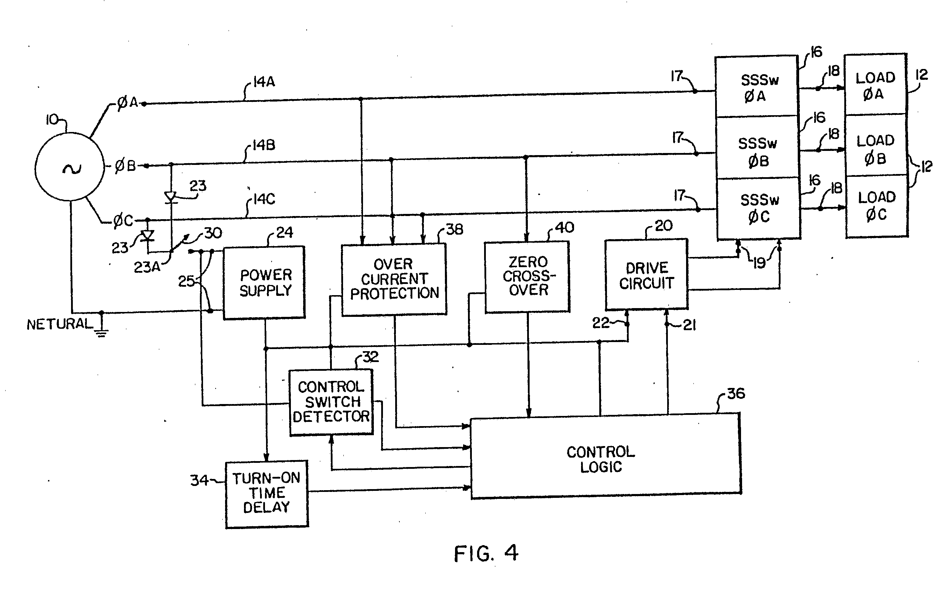

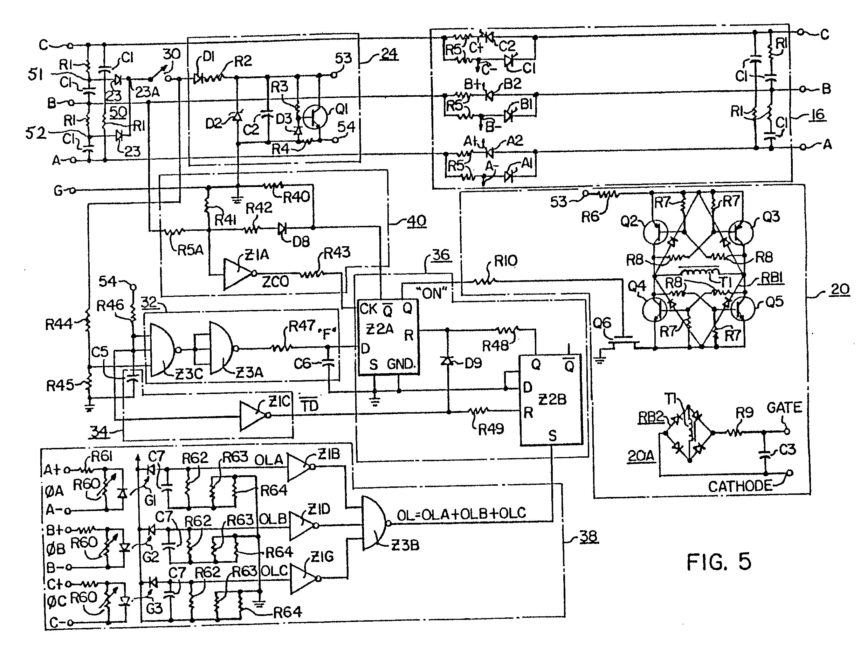

Referring to Figure 4, a three phase solid state circuit breaker is illustrated in a one-line diagram for controlling the supply of power from a three phase AC supply 10 to loads 12 on respective AC lines 14A, 14B and 14C referred to as phases A, B, and C. For each phase there is a solid state switch (SSSw) 16, sometimes referred to as a static power switch or the like, having supply and load terminals 17 and 18 connected respectively to each phase of the supply and loads associated with that phase. The solid state switches 16 also have drive terminals 19 for the selective application of predetermined drive signals from drive circuit 20 to alter the conduction state of the switches 16. As will be seen in Figure 5 the static switches 16 together comprise three sets of pairs of SCR's connected in inverse parallel configurations to provide full cycle conduction paths for load currents in all three phases.

The required DC voltage levels in the internal circuitry are provided by a power supply 24 shown connected at terminals 25 between two of the AC supply voltage phases (arbitrarily shown as phases B and C) and to a reference potential (ground or neutral). As shown in the example of Fig. 4, phases B and C are each connected through respective diodes 23 to a common point 23A. Between point 23A and the power supply 24 is located a manually operable control switch 30 for giving the apparatus the character of a circuit breaker. The power supply circuit 24 together with diodes 23 comprise elements for the conversion of AC power to DC power with whatever filtering and regulation is desirable. Consistent with preferred practice, the apparatus is powered merely from the AC line without requiring any separate DC power supply unassociated with the line. Thus, this apparatus may be referred to as "self powered" or "self energized".

The control switch 30 between the AC supply 10 and the power supply 24 enables deenergization of the circuit breaker, except for the solid state switches, to provide a highly reliable means of removing load power. There is provided a means for detecting the closing of the control switch 30, shown in Figure 4 as a control switch detector 32. There is also a turn-on time delay means 34 to insure that upon the control switch 30 being closed the power supply 24 can reach a voltage level adequate to continuously operate. Signals from the control switch detector 32 and the turn-on time delay 34 are supplied to a control logic circuit portion 36. The control logic circuit 36 provides signals to the drive circuit 20 in accordance with inputs it receives from the control switch detector 32, the turn-on time delay circuit 34, an overcurrent protection circuit 38 and a zero crossover circuit 40.

The zero crossover circuit 40 is to provide accurate turn-on and turn-off synchronization for the circuit breaker with respect to the AC supply voltage zero crossover. Despite the presence of three phases, it is only necessary in accordance with this invention to use the zero crossover of a single phase as the synchronizing parameter and to permit the other two phases to be respectively plus 120° and minus 120° out of phase with that on which the monitored zero crossover occurs.

The overcurrent protection circuit 38 provides inverse time overload tripping in the event of excessive loads or load faults on any one of the individual phases. The protection circuit 38 is generally of such a nature that it receives signals from each of the three phases for comparison with a reference level in determining the state of the signal to be applied to the control logic circuit.

An additional function that can be provided in accordance with known technology, not shown, is an indication function for indication of on or tripped conditions of the breaker.

The nature and operation of circuit breakers in accordance with this invention will be better understood by reference to Figure 5 which shows a specific embodiment in accordance with this invention.

The control switch 30 is connected between the phase conductors A, B and C and the power supply 24 by an input network 40 comprising a resistor R1 and a capacitor C1 between each pair of phases. Two diode rectifiers 23 are respectively connected to network points 51 and 52 and to common point 23A. The power supply 24 is energized and deenergized by the closing and opening of the single pole, single throw control switch 30 in order to convert the AC line voltage to a DC power level to energize the internal circuit breaker circuitry. Higher voltage, +DC, is produced at terminal 53 and a lower DC voltage (+12 V) at terminal 54. The AC line voltage is rectified and filtered to provide the DC supply voltage and also a regulated +12 volt DC for logic circuits. Because of the different nature of the overcurrent protection circuit in this embodiment, from that of the embodiment of Figures 1—3, it is not required that there be an additional lower regulated DC voltage for its operation. The power supply circuit is designed for working in both three phase and single phase applications and also to be usable with AC power sources of any frequency over a wide range, such as 60 hertz through 400 hertz, by employing resistive, as opposed to reactive, elements for voltage dropping. Individual components of power supply circuit 24 are further identified, by way of example, in the Component Table below.

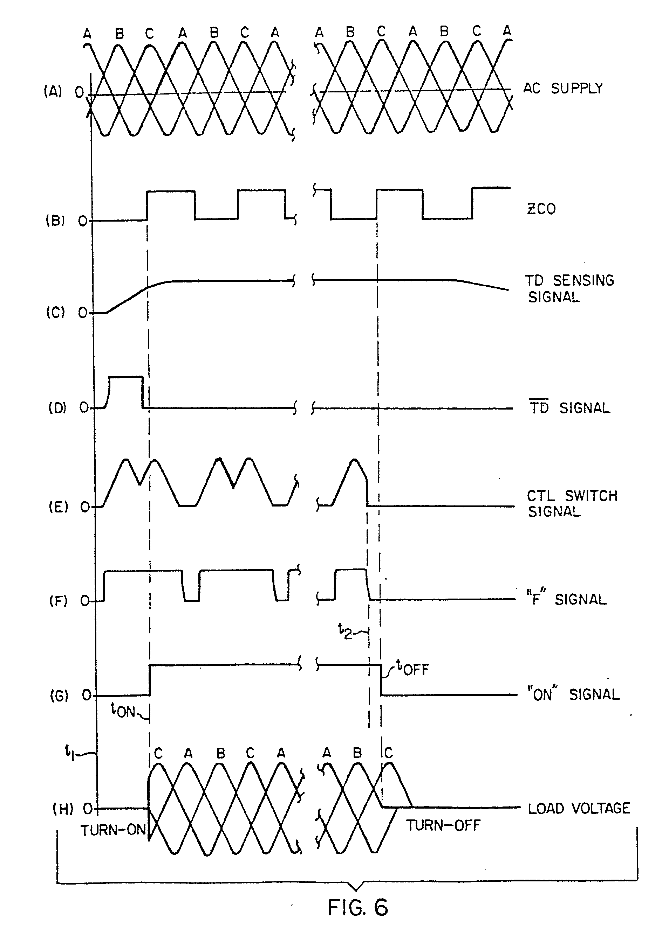

The zero crossover circuit 40 is substantially in accordance with that of the previous embodiment with the addition of resistor R40 connected between ground and diode D8. In the instant embodiment, this circuit senses the AC source voltage appearing between line terminals B and G and generates a quasi-squarewave whose positive-rising edges (which are the zero crossover operating times) coincide with the 180° zero crossings of $V_{AB}$ as shown in the waveform A of Figure 6. Selection of only one of the zero crossover points is sufficient for the power continuity feature which reduces on saturation and transients with electromagnetic loads.

It is to be noted that AC input signal to zero crossover circuit 40 is applied through R5A even if the control switch 30 is not closed so that on turn-off proper synchronization with the 180° zero crossover will be maintained. Also, deliberate earlier occurrence of the zero crossover signal positive leading edge is obtained in the on state to preclude extra half cycle load power by leading power factor load currents. This is accomplished by loading the zero crossover input sensing node in the on state by the resistor R42 and diode D8 to the off signal which is low when the circuit breaker is on.

Previously known solid state power controller designs for three phase apparatus used individual zero crossover sensing and independent closing on each phase. This not only adds considerable complexity to the circuit but causes a significant amount of saturation at turn-on with three phase loads because it takes two-thirds of the first cycle of load power to have balanced power in the loads. In contrast, as described herein, at turn-on all three phase voltages are applied to the load at the same instant with minimal, controlled, turn-on transient line currents resulting.

The control logic circuit 36 is substantially in accordance with the previous embodiment and provides a logic "ON" signal that turns the circuit breaker on and off in response to the control switch and the overcurrent protection circuit. Circuit 36's inputs consist of the control signal from the switch detector circuit 32, the zero crossover signal, a trip lockout from the overcurrent protection and the plus DC supply. The detector 32's control signal is generated as a quasi-squarewave from the AC control switch signal using gates Z3C and Z3A. Referring to the waveforms of Figure 6 it is seen how the "F" signal timing and time lag at the D input of flip-flop Z2A is designed to assure the "F" signal always is positive at the zero crossover operating times when the control switch 30 is closed and the turn-on time delay has elapsed. It is therefore seen that the zero crossover circuit 40, the control switch detector circuit 32, the turn-on time delay circuit 34 and the control logic circuit 36 together cooperate to produce an "on" signal from the control logic circuit 36 to the drive circuit 20 only upon the closing of the control switch 30 and after the time delay so the power supply 34 is up to a level permitting continuous operation, and the correct zero crossover occurs.

The overload protection circuit 38 provides inverse type overload tripping in the event of excessive loads or load faults in any one or all of the three phases. The overload signal OL is provided to the control logic circuit 36 in a manner such that if there is an overcurrent on any one phase all phases are tripped. This circuit uses optical isolation elements G1, G2 and G3 for each of the phases in the manner generally described in U.S. Patent 3,925,709, which should be referred to. However, a significant modification in the three sensing circuits reduces the power switch losses at high current ratings. This modification consists of utilizing a gate-to-cathode voltage drop (across terminals A+ and A−, B+ and B−, C+ and C− in switch circuit 16), which is a small magnitude voltage of about 0.88 volts, to obtain a portion of the DC sensing voltage for overload sensing. The signal identification at the input of the sensing circuits corresponds to the points indicated in the power switch circuit portion 16. This means that the resistance value of the shunt resistors R60 can be reduced about 50% of the value required by the previous circuit that employs current sensing in accordance with U.S. Patent 3,811,073, with a corresponding decrease in switch voltage drop and increase in efficiency.

Schmitt trigger gates Z1B, Z1D and Z1G and gate Z3B cooperate to provide the overload fault signal which actuates the trip lockout Z2B of the control logic circuit 36. The trip lockout signal then causes Z2A to be reset or turned off, removing the drive signal to the static power switch. The trip lockout flip-flop Z2B remains in the set mode until it is reset by opening the control switch 30.

The static power switch 16 is generally in accordance with the previous embodiment and its drive circuit 20 uses the same concepts employing a Royer oscillator with its transistors connected in a bridge configuration. This allows the use of the single winding primary with multiple secondaries for the oscillator transformer.

Circuit portion 20A is one of six gate drive circuits which are each connected across the gate and cathode of a respective SCR of power switch 16. Each uses one part of a six section secondary winding of transformer T1.

Reference to the waveforms of Figure 6 shows the sequencing of the various supply and control signals that result in the operation of the circuit. Waveform A is the multiphase AC supply. Waveform B is the zero crossover signal (ZCO), required for only one phase (phase B). Waveform C is the time delay sensing signal TD for circuit 34 while waveform D is the time delay signal itself $\overline{TD}$ supplied by circuit 34 to the logic circuit 36. Waveform E is the control switch signal from 30 and waveform F is the switch detector output signal. Waveform G is the "ON" signal to the drive circuit. Waveform H is the AC load voltage.

8

**0016646**

If the control switch 30 is closed at time t1 and opened at a time t2, it can be seen how the load power is applied, with delay for correct synchronization, at $t_{on}$ and removed at $t_{off}$. Phases A and C terminate within a half cycle at their zero points after $t_{off}$.

The following tables present data on the performance of the circuit and suitable component value as has been utilized in the operation of the circuit.

TABLE I

This table presents how the circuit in accordance with this invention, such as Fig. 5, is connectable for use in various three phase and single phase applications:

| Type designation | Circuit configuration | Input power terminals | Terminal "G" connection |
|---|---|---|---|
| I (Fig. 7) | $3\phi$, 115 V/L-L-$\Delta$ | A-B-C | A |
| II (Fig. 8) | $3\phi$, 208 V/L-L-Y | A-B-C | Neutral |
| III (Fig. 9) | $1\phi$, 115 V & both lines controlled | A-B | A |
| IV (Fig. 10) | $1\phi$, 115 V & one line controlled | B-Gnd | Gnd |
| V (Fig. 11) | $1\phi$, 115 V, 3X current rating | (A to B to C)-Gnd | Gnd |

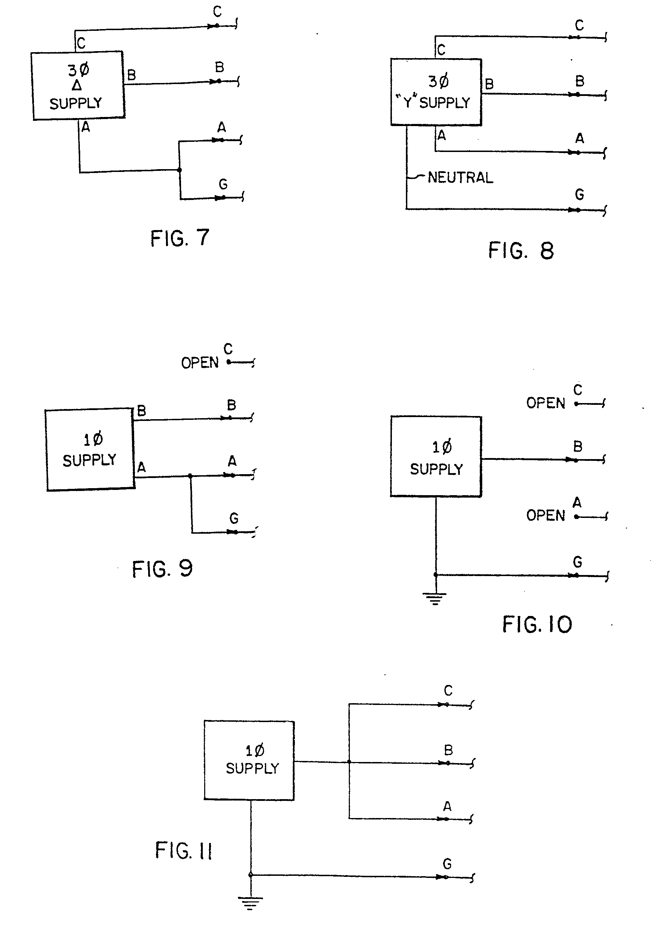

Figs. 4 through 11 respectively illustrate connections at input terminals C, B, A and G for circuit types I through V.

TABLE II

The following data is actual performance data of a circuit in accordance with Fig. 5 that has been made and tested:

| | |
|---|---|
| Temperature ambient range tested | $-25°C$ to $+75°C$ |
| AC Source voltage range | 80 VRMS to 135 VRMS |
| AC Source frequencies | 60 Hz and 400 Hz |
| SSCB Circuit/load configurations | All 5 types (table I) |
| SSCB Dissipation/efficiency at 10A/120 V/$3\phi$ | 45.3W/98.8% |
| "OFF" State dissipation at 10A/120 V/$3\phi$ | .04W* |
| "Tripped" State dissipation at 10A/120 V/$3\phi$ | 2.10W* |
| *Includes power switch leakage dissipation | |
| DC Power supply voltage: | |
| at point 53 (+DC) | 50 V |
| at point 54 | 12 V |

TABLE III

The following are suitable components used in the circuit of Fig. 5 presented by way of further example:

Input network 50 and power supply 24

| | |
|---|---|
| R1 | 47 ohms, each |
| C1 | 0.01 mf |
| D1 | 1N649 |
| R2 | 1,000 ohms |
| D2 | 70 V Zener |
| C2 | 22 mf |
| R3 | 50,000 ohms |
| D3 | 13 V Zener |
| Q1 | 2N3501 |
| R4 | 10,000 ohms |

9

# 0 016 646

### Static switch 16 and drive circuit 20

| | |
|---|---|
| All SCR's | 2N3899 each |
| Q2 and Q3 | 2N5680 each |
| Q4 and Q5 | 2N3019 each |
| Q6 | 2N6660 |
| RB1 and RB2 | VE 18X each |
| R5 | 0.03 ohm each |
| R1 | 47 ohms |
| C1 | 0.01 mf |
| R6 | 200 ohms |
| R7 | 5,000 ohms each |
| R8 | 51,000 ohms each |
| R9 | 22 ohms each |
| C3 | 0.068 mf each |
| R10 | 10,000 ohms |

### Logic 36 and control circuits 32, 34, 38 & 40

| | |
|---|---|
| Z1A, Z1B, Z1C, Z1D, Z1D and Z1E | Each a part of MC14584B hexagonal Schmitt trigger |
| Z2A and Z2B | Each a part of MC14013B dual "D" flip-flop |
| Z3A, Z3B and Z3C | Each a part of MC14023B triple NAND |
| R40 | 4,700 ohms |
| R5A | 500,000 ohms |
| R41 | 250,000 ohms |
| R42 | 50,000 ohms |
| R43 | 500,000 ohms |
| D8, D9 | 1N914 |
| R44 | 1 Meg . ohm |
| R45, R46, R47, R48 & R49 | 500,000 ohms each |
| C5 | 0.1 mf |
| C6 | 200 pf |
| G1, G2, G3 | 9N23 each |
| R61 | 40 ohms each |
| C7 | 2.2 mf each |
| R62 | 2 ohms each |
| R63 | 18,000 ohms each |
| R64 | 24,000 ohms each |

## Claims

1. A solid-state circuit breaker for alternating current applications such as for use in between an AC voltage supply and a load, of the type comprising a solid-state power switch (16) for connection between an AC voltage supply (10) and a load (12); power supply means (24) for developing a control-DC voltage from the applied AC voltage; a manually operable control switch (30); zero crossover-circuit means (40) having connections with the AC voltage supply (10) and with said power supply means (24) for producing a signal indicative of the zero crossover of at least one phase of the AC voltage supply; control logic means (36) to supply an ON signal when the zero crossover signal occurs; and drive circuit means (20) responsive to the ON signal for application of signals to the power switch (16) to initiate conduction thereof, characterized by:

said manually operable control switch (30) being connected between the AC voltage supply (10) and said power supply means (24);

said zero crossover-circuit means (40) being connected to the AC voltage supply both directly and through said control switch (30) and said power supply means (24), for producing said signal indicative of the zero crossover of at least one phase of the AC supply;

a turn-on time delay circuit means (34) provided for producing a signal indicative of said power supply means (24) having achieved full operating capability after the closing of said control switch (30);

10

switch detector circuit means (32) provided for producing a signal in response to both the closing of said control switch (30) and the occurrence of the signal from said turn-on time delay circuit means (34);

and said control logic means (36) producing an ON signal only when said zero crossover signal occurs in the presence of the signal from said switch detector circuit means (32).

2. A solid-state circuit breaker in accordance with claim 1 wherein: said zero crossover signal is a substantially square wave signal between a zero and a one state and the upward rising portion of said square wave occurs substantially with the occurrence of a negative going zero crossover of the AC supply voltage.

3. A solid-state circuit breaker in accordance with Claim 2 wherein: said switch detector (32) puts out a signal which is substantially a square wave whose pulses coincide with the occurrence of said upward zero crossover signal and cause the production of an ON signal at the first said zero crossover signal occurring after the closing of said control switch (30).

4. A solid-state circuit breaker in accordance with claim 1 further comprising:

overload protection circuit means (38) responsive to an overload condition in said load circuit to produce a signal disabling said control logic (36) from the production of an ON signal.

5. A solid-state circuit breaker in accordance with claim 2 wherein: said zero crossover signal coincides with the occurrence of said negative going zero crossover of the AC supply voltage except when said power switch (16) is ON during which time said zero crossover signal occurs slightly prior to said negative going zero crossover of the AC supply voltage for providing positive turn-off insuring against extra half-cycle load power by leading power factor load current.

6. A solid-state circuit breaker in accordance with claim 1 wherein: said zero crossover circuit means (40) produces said zero crossover signal independent of said power supply means (24) and the state of said control switch (30); said power supply means (24) includes energy storage means (C1) for maintaining an interval of operation upon opening of said manual control switch (30), and said switch detector circuit means (32) responds to the opening of said control switch (30) to terminate said switch detector signal within one-half cycle of the AC voltage supply, so as to cause said power switch (16) to be maintained in the ON state, following opening of said control switch (30), until the occurrence of the next zero crossing signal of the AC voltage supply.

7. A solid-state circuit breaker according to claim 1 wherein:

said solid-state switch (16) comprises a pair of SCR's connected in an inverse-parallel configuration, each of said SCR's having a cathode, an anode and a gate terminal; first and second resistors connected respectively in series with each of said SCR's; one of said SCR gate electrodes being connected directly to one side of a current sensing device whose other side is connected to a connection point between the other of said SCR's and its resistor.

8. A solid-state circuit breaker according to claim 7 wherein:

said current sensing device is a light emitting diode comprising part of an overcurrent protection circuit (38) for said circuit breaker.

9. A solid-state circuit breaker according to claim 8 wherein:

said protection circuit (38) comprises optical isolation means for an AC supply phase, with current sensing according to voltage drops developed across resistors connected with inverse parallel SCR's in said power switch (16).

**Patentansprüche**

1. Festkörperstromkreisunterbrecher für Wechselstrom zur Verwendung zwischen einer Wechselstromspannungsquelle und einer Last, bestehend aus einem Festkörperschalter (16), der zwischen einer Wechselspannungsquelle (10) und einer Last (12) angeordnet ist; einer Stromversorgungsquelle (24) zum Erzeugen einer Steuergleichstromspannung von der angelegten Wechselstromspannung; einem von Hand betätigbaren Steuerschalter (30); einem Null-Übergangskreis (40) mit Anschlüssen zur Wechselstromspannungsquelle (10) und zur Stromversorgungsquelle (24), um ein Signal zu erzeugen, das kennzeichnend ist für den Nullübergang von mindestens einer Phase der Wechselspannungsquelle; einer Steuerlogikschaltung (36), um ein AN-Signal zu senden, wenn ein Nullübergangssignal auftritt; und einem auf das AN-Signal ansprechenden Antriebsstromkreis (20) zum Aufbringen von Signalen auf den Schalter (16), um dessen Leitung initiieren,

dadurch gekennzeichnet, dass der handbetätigbare Steuerschalter (30) zwischen der Wechselspannungsquelle (10) und der Stromversorgungsquelle (24) geschaltet ist;

der Null-Übergangskreis (40) sowohl direkt als auch über den Steuerschalter (30) und die Stromversorgungsquelle (24) an der Wechselspannungsquelle angeschlossen ist, um das für den Nullübergang kennzeichnende Signal von mindestens einer Phase der Wechselstromquelle zu erzeugen;

ein Einschaltzeit-Verzögerungskreis (34) zur Erzeugung eines für die Stromversorgungsquelle (24) kennzeichnenden Signals vorgesehen ist, die nach Schliessen des Steuerschalters (30) die volle Arbeitsleistung erreicht hat;

ein Schalteranzeigekreis (32) vorgesehen ist, der ansprechend auf das Schliessen des Steuerschalters (30) und das Auftreten des Signals des Einschaltzeit-Verzögerungskreises (34) ein Signal erzeugt; und

die Steuerlogikschaltung (36) nur dann ein AN-Signal sendet, wenn das Nullübergangssignal in Gegenwart des Signals vom Schalteranzeigekreis (32) auftritt.

2. Festkörperschaltkreisunterbrecher nach Anspruch 1, dadurch gekennzeichnet, dass das Nullübergangssignal im wesentlichen ein Rechteckwellensignal zwischen einem Null- und einem Ein-Zustand ist und der aufwärts gerichtete Teil der Rechteckwelle im wesentlichen mit dem Auftreten eines negativ laufenden Nullübergangs der Wechselstromnetzspannung erscheint.

3. Festkörperschaltkreisunterbreches, nach Anspruch 2, dadurch gekennzeichnet, dass der Schalteranzeigekreis (32) ein Signal sendet, das im wesentlichen eine Rechteckwelle ist, deren Impulse mit dem Auftreten des aufwärts gerichteten Nullübergangssignals koinzidieren und beim ersten nach dem Schliessen des Steuerschalters (30) auftretenden Nullübergangssignal ein AN-Signal bewirken.

4. Festkörperschaltkreisunterbrecher nach Anspruch 1, dadurch gekennzeichnet, dass ein Überlastungsschutzkreis (38) vorgesehen ist, der auf einen Überlastungszustand im Lastkreis anspricht und ein Signal sendet, das die Steuerlogik (36) für die Erzeugung eines AN-Signals sperrt.

5. Festkörpershaltkreisunterbrecher nach Anspruch 2, dadurch gekennzeichnet, dass das Nullübergangssignal mit dem Auftreten des negativ gerichteten Nullübergangs der Wechselstromspannung koinzidiert, ausgenommen wenn der Festkörperschalter (16) auf AN steht, wobei während dieser Zeit das Null-übergangssignal etwas früher auftritt als der negativ gerichtete Nullübergang der Wechselstromspannung, um eine positive Abschaltsicherung gegen einen extra Halbperioden-Laststrom durch voreilenden Leistungsfaktor Laststrom zu schaffen.

6. Festkörperschaltkreisunterbrecher, nach Anspruch 1, dadurch gekennzeichnet, dass der Null-Übergangskreis (40) unabhängig vom Stromversorgungskreis (24) und dem Zustand des Steuerschalters (30) ein Nullübergangssignal erzeugt; der Stromversorgungskreis (24) zur Aufrechterhaltung eines Arbeitsintervalls nach dem Öffnen des handbetätigbaren Steuerschalters (30) einen Energiespeicher (C1) aufweist und der Schalteranzeigekreis (32) auf das Offnen des Steuerschalters (30) anspricht, um das Anzeigesignal innerhalb einer Halbperiode der Wechselspannungslieferung zu beenden, derart, dass der Festkörperschalter (16) in der AN-Stellung gehalten wird, anschliessend an das Öffnen des Steuerschalters (30), bis das nächste Nullübergangssignal der Wechselspannungszufuhr auftritt.

7. Festkörperschaltkreisunterbrecher nach Anspruch 1, dadurch gekennzeichnet, dass der Festkörperschalter (16) ein Paar SCR (Gleichrichter) aufweist, die in antiparalleler Anordnung geschaltet sind, wobei jeder SC-Gleichrichter eine Kathode, eine Anode und einen Gateanschluss aufweist;

ein erster und zweiter Widerstand in Reihe mit jedem der SC-Gleichrichter angeschlossen ist; eine der SCR-Gateelektrode direkt mit einer Seite einer Stromabtasteinrichtung verbunden ist, deren andere Seite an einem Verbindungspunkt zwischen dem anderen SC-Gleichrichter und seinem Widerstand angeschlossen ist.

8. Festkörperschaltkreisunterbrecher nach Anspruch 7, dadurch gekennzeichnet, dass die Stromabtasteinrichtung eine Lichtemittierende Diode ist, die Teil eines Überstromschutzkreises (38) für den Stromkreisunterbrecher enthält.

9. Festkörperschaltkreisunterbrecher nach Anspruch 8, dadurch gekennzeichnet, dass der Überstromschutzkreis (38) optische Trennmittel für eine Wechselstromphase aufweist, mit Stromabtastung entsprechend über den Widerständen auftretenden Spannungsabfällen, die mit den antiparallel geschalteten SC-Gleichrichtern im Steuerschalter (16) verbunden sind.

**Revendications**

1. Interrupteur à l'état solide pour courant alternatif destiné à être monté entre une alimentation en tension alternative et une charge, interrupteur du type comportant un commutateur de puissance (16) en technique état solide pour être branché entre une alimentation en tension alternative (10) et une charge (12), un moyen d'alimentation de puissance (24) pour créer une tension continue de commande à partir de la tension alternative appliquée; un commutateur de commande (30) actionné manuellement; un circuit de passage à zéro (40) ayant des connexions avec l'alimentation en tension

**0 016 646**

alternative (10) et l'alimentation de puissance (24) pour donner un signal indicateur du passage à zéro d'au moins une phase de l'alimentation en tension alternative; un moyen logique de commande (36) pour fournir un signal de conduction lorsque se produit le signal de passage à zéro et un circuit d'entraînement (20) répondant au signal de conduction pour appliquer les signaux au commutateur de puissance (16) pour initialiser sa conduction, caractérisé par:

— le commutateur de commande (30) actionné manuellement est branché entre l'alimentation en tension alternative (10) et l'alimentation de puissance (24),

— le circuit de passage à zéro (40) est relié à l'alimentation en tension alternative à la fois directement et par l'intermédiaire du commutateur de commande (30) et le moyen d'alimentation de puissance (34) pour donner le signal indicateur de passage à zéro d'au moins une phase de l'alimentation alternative;

— un circuit de retard de temps de branchement (34) prévu pour donner un signal indiquant que le moyen d'alimentation de puissance (24) est arrivé à la capacité complète de fonctionnement après fermeture du commutateur de commande (30);

— un circuit détecteur de commutateur (32) pour donner un signal en réponse à la fois à la fermeture du commutateur de commande (30) et à l'arrivée du signal du circuit de retard de temps de branchement (34);

— et le moyen logique de commande (36) produisant un signal de branchement seulement lorsque se produit le signal de passage à zéro en présence du signal du circuit détecteur de commutateur (32).

2. Interrupteur à l'état solide pour courant alternatif selon la revendication 1, caractérisé en ce que le signal de passage à zéro est essentiellement un signal rectangulaire entre un état zéro et un état UN et la partie montante de l'onde rectangulaire se produit essentiellement avec l'arrivée d'un passage à zéro dans le sens négatif pour la tension d'alimentation alternative.

3. Interrupteur à l'état solide selon la revendication 2, caractérisé en ce que le détecteur de commutateur (32) fournit un signal qui correspond essentiellement à une onde rectangulaire dont les impulsions coïncident avec l'arrivée du signal de passage à zéro dans le sens montant et provoque la production d'un signal de branchement lorsque se produit le premier signal de passage à zéro après la fermeture du commutateur de commande (30).

4. Interrupteur à l'état solide selon la revendication 1, caractérisé en ce qu'il comprend en outre un circuit de protection de surcharge (38) répondant à un état de surcharge dans le circuit de charge pour produire un signal interdisant à la logique de commande (36) de produire un signal de branchement.

5. Interrupteur à l'état solide, selon la revendication 2, caractérisé en ce que le signal de passage à zéro coïncide avec l'arrivée du passage à zéro dans le sens négatif de la tension d'alimentation alternative, sauf si le commutateur de puissance (16) est branché pendant que le signal de passage à zéro se produit, légèrement avant le passage à zéro dans le sens négatif pour la tension d'alimentation alternative pour donner une sécurité positive d'ouverture pour un demi-cycle de puissance de charge supplémentaire par l'avance de phase du facteur de puissance du courant de charge.

6. Interrupteur à l'état solide selon la revendication 1, caractérisé en ce que le circuit de passage à zéro (40) donne un signal de passage à zéro indépendamment du moyen d'alimentation de puissance (24) et de l'état du commutateur de commande (30); le moyen d'alimentation de puissance (24) comportant un moyen de stockage d'énergie (CI) pour conserver un intervalle de fonctionnement lors de l'ouverture du commutateur de commande manuelle (30) et le circuit de détecteur de commutation (32) répond à l'ouverture du commutateur de commande (30) pour terminer le signal de détecteur du commutateur dans un demi-cycle de l'alimentation en tension alternative de façon que le commutateur de puissance (16) soit maintenu à l'état fermé à la suite de l'ouverture du commutateur de commande (30) jusqu'à l'arrivée du signal de passage à zéro suivant de l'alimentation en tension alternative.

7. Interrupteur de circuit à l'état solide, selon la revendication 1, caractérisé en ce que le commutateur à l'état solide (16) comporte une paire de composants SCR branchés suivant un montage anti-parallèle, chacun des composants SCR ayant une borne de cathode, une borne d'anode et une borne de porte;

une première et une seconde résistances étant respectivement branchées en série sur chacun des composants SCR;

l'une des électrodes de porte de composant SCR étant branchée directement d'un côté d'un dispositif sensible au courant et dont l'autre côté est relié à un point de jonction entre l'autre composant SCR et sa résistance.

8. Interrupteur à l'état solide selon la revendication 7, caractérisé en ce que le dispositif sensible au courant est une diode photo-émissive constituant une partie d'un circuit de protection de surintensité (38) pour cet interrupteur.

**0 016 646**

9. Interrupteur à l'état solide selon la revendication 8, caractérisé en ce que le circuit de protection (38) comporte un moyen d'isolation optique pour la phase d'alimentation alternative, avec détection de courant en fonction des chutes de tension aux bornes des résistances reliées au mountage anti-parallèle des composants SCR dans le commutateur de puissance (16).

14

FIG.I.

FIG.2.

FIG.3.

FIG. 4

0016 646

FIG. 5

FIG. 6

0 016 646

FIG. 7

FIG. 8

FIG. 9

FIG. 10

FIG. 11

7